(19) **Europäisches Patentamt**

**European Patent Office**

**Office européen des brevets**

(11) Veröffentlichungsnummer: **0 299 453 B1**

(12) **EUROPÄISCHE PATENTSCHRIFT**

(45) Veröffentlichungstag der Patentschrift: **18.03.92**

(51) Int. Cl.⁵: **H05K 3/36**, H05K 3/46

(21) Anmeldenummer: **88111215.5**

(22) Anmeldetag: **13.07.88**

(54) Verfahren zur Herstellung von gedruckten Schaltungen.

(30) Priorität: **15.07.87 DE 3723413**

(43) Veröffentlichungstag der Anmeldung:
**18.01.89 Patentblatt 89/03**

(45) Bekanntmachung des Hinweises auf die
Patenterteilung:
**18.03.92 Patentblatt 92/12**

(84) Benannte Vertragsstaaten:
**CH DE FR GB LI**

(56) Entgegenhaltungen:
**EP-A- 0 117 809**
**EP-A- 0 163 581**

(73) Patentinhaber: **Vaas-Lt GmbH**
**Güglingstrasse 47**
**W-7070 Schwäbisch Gmünd(DE)**

(72) Erfinder: **Stohrer, Günther**
**Brühlstrasse 20**
**W-7340 Geislingen 5(DE)**
Erfinder: **Balla, Gerhard, Dipl.-Ing.**
**Panoramastrasse 8**
**W-7341 Amstetten(DE)**

(74) Vertreter: **Schwabe - Sandmair - Marx**
**Stuntzstrasse 16**
**W-8000 München 80(DE)**

# Beschreibung

Die Erfindung betrifft ein Verfahren zur Herstellung von Gedruckten Schaltungen in starrflexibler Mehrlagentechnik mit einem oder mit mehreren flexiblen Bereichen, die jeweils eine oder mehrere flexible Ebenen aufweisen, wobei die fertiggestellten Gedruckten Schaltungen in einer abgewinkelten Konfiguration in eine Halterung eingesetzt und gehalten werden.

Es ist bereits ein derartiges Verfahren zur Herstellung von Gedruckten Schaltungen in starrflexibler Mehrlagentechnik bekannt. Bei diesem bekannten Verfahren werden beim Aufbau starrflexibler Mehrlagenschaltungen die flexiblen wie die starren Lagen in einem sogenannten Nutzenformat miteinander - zum Teil auch in sequentieller Arbeitsweise - unter Druck und Temperatur mittels Klebefolien verpreßt. Die fertiggestellten Gedruckten Schaltungen werden dann mittels der bekannten Leiterplattentechnologien weiterbehandelt bzw. gefräst oder gestanzt.

Bei dem Einbau dieser nach herkömmlichen Verfahren hergestellten Gedruckten Schaltungen in eine vorgesehene räumliche Konfiguration in ein die betreffende Baugruppe aufnehmendes Gehäuse kommt es bei Mehrlagenschaltungen mit zwei oder mehr flexiblen Ebenen im Bereich der Biegestellen zu hohen mechanischen Spannungen, durch die die Funktionssicherheit der Leiterplatte sehr beeinträchtigt wird.

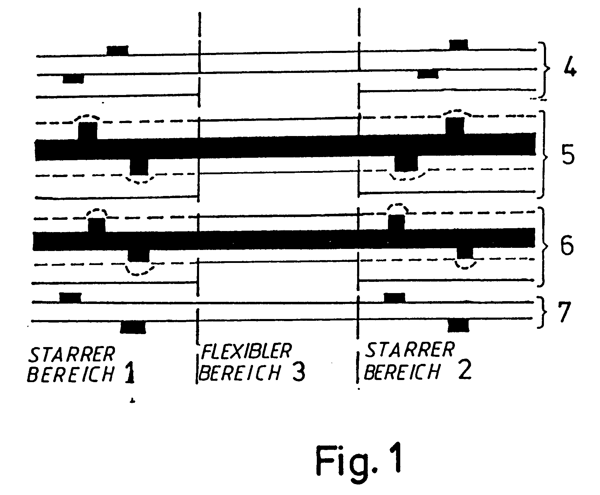

Figur 1 zeigt schematisch eine Schnittdarstellung einer Gedruckten Schaltung in starrflexibler Mehrlagentechnik. Die gezeigte Gedruckte Schaltung enthält einen starren Bereich 1 und 2 und auch einen flexiblen Bereich 3, der zur späteren Veränderung der räumlichen Konfiguration der Baugruppe bzw. der Gedruckten Schaltung dienen kann. Bei dem gezeigten Ausführungsbeispiel umfaßt die Gedruckte Schaltung einen Außenkern mit Leiterbild und einer Klebefolie 4, ferner einen flexiblen Kern mit Leiterbild und Deckfolie, die auch partiell aufgetragen sein kann kombiniert mit einer Klebefolie, wobei diese letztere Anordnung mit 5 bezeichnet ist, ferner ist ein weiterer unterer flexibler Kern mit Leiterbild und Deckfolie und einer Klebefolie vorhanden, wobei dieser Bereich mit 6 bezeichnet ist und schließlich ist noch ein unterer Außenkern mit Leiterbild 7 vorgesehen.

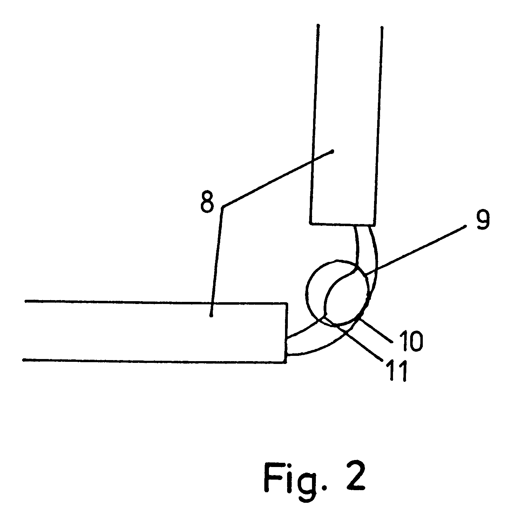

In Figur 2 ist schematisch eine Gedruckte Schaltung in der endgültigen gewünschten bzw. abgewinkelten Konfiguration dargestellt. Mit 8 sind die starren Teile der Gedruckten Schaltung bezeichnet, während mit 9 eine kritische Stelle bei mechanischer Beanspruchung (Biegebeanspruchung) bezeichnet ist.

Dieser Bereich kann mehrere flexible Lagen umfassen, die mit 10 und 11 bezeichnet sind. Bei dieser bekannten Anordnung bzw. Konstruktion wird die Zuverlässigkeit der starrflexiblen Mehrlagenschaltungen, insbesondere im Falle von zwei oder mehr flexiblen Innenkernen aufgrund der gleichen Längen in den flexiblen Bereichen stark beeinträchtigt.

Die der Erfindung zugrunde liegende Aufgabe besteht darin, ein Verfahren zur Herstellung von Gedruckten Schaltungen der angegebenen Gattung zu schaffen, welches die Möglichkeit bietet, Gedruckte Schaltungen so herzustellen, daß in der späteren abgewinkelten Konfiguration der Gedruckten Schaltung, wenn sie in ein entsprechendes Gehäuse eingebaut ist, keinerlei mechanische Spannungen mehr auftreten können, durch die die Zuverlässigkeit der Gedruckten Schaltung vermindert wird.

Ausgehend von dem Verfahren der eingangs definierten Art wird diese Aufgabe erfindungsgemäß dadurch gelöst, daß bei der Layouterstellung die für die spätere Konfiguration der abgewinkelten starrflexiblen Gedruckten Schaltung nötigen unterschiedlichen Längen ($l_1$, $l_2$,...$l_n$) der vorgesehenen flexiblen Ebenen so eingestellt werden, daß die Gedruckte Schaltung ohne Biegebeanspruchung in ihre spätere räumliche abgewinkelte Konfiguration gebracht werden kann.

Durch das erfindungsgemäße Herstellungsverfahren wird die Gedruckte Schaltung für ihren späteren Einbau so vorbereitet, daß die Gedruckte Schaltung von selbst, das heißt ohne zusätzliche Biegebeanspruchung, ihre spätere, räumlich vorgesehene Konfiguration annimmt. Dabei spielt das Ausmaß der Abwinkelung von Teilen der Gedruckten Schaltung keinerlei Rolle und es lassen sich sogar Anordnungen realisieren, bei welchen Abschnitte der Gedruckten Schaltungen um 180 ° und mehr abgewinkelt angeordnet werden können.

Besonders vorteilhafte Ausgestaltungen und Weiterbildungen der Erfindung ergeben sich aus den Unteransprüchen 2 bis 9.

Im folgenden wird die Erfindung anhand eines Ausführungsbeispiels unter Hinweis auf die Zeichnung näher erläutert. Es zeigen:

Figur 1     eine schematische Schnittdarstellung einer herkömmlichen Gedruckten Schaltung in starrflexibler Mehrlagentechnik;

Figur 2     eine schematische Seitenansicht einer herkömmlichen Gedruckten Schaltung, die in einer abgewinkelten endgültigen Einbaukonfiguration gezeigt ist; und

Figur 3     eine schematische Seitenansicht einer Gedruckten Schaltung in starrflexibler Mehrlagentechnik, die nach dem erfindungsgemäßen Verfahren hergestellt wurde.

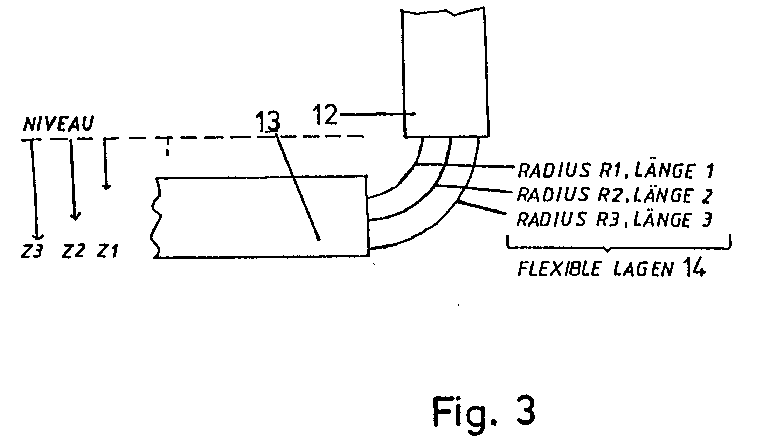

Gemäß Figur 3 umfaßt eine Gedruckte Schaltung zwei starre Bereiche 12 und 13, die jeweils an einem Ende über einen flexiblen Bereich bzw. flexible Lagen 14 miteinander verbunden sind. Es sei darauf hingewiesen, daß die drei gezeigten Ebenen im flexiblen Bereich einen unterschiedlichen Krümmungsradius R1, R2 und R3 aufweisen, wobei sich diese Ebenen auch in den starren Bereichen 12 und 13 fortsetzen können.

Erfindungsgemäß werden bereits bei der Layouterstellung der Gedruckten Schaltung die für die spätere Konfiguration der gewinkelten starrflexiblen Schaltung nötigen, unterschiedlichen Längen der vorgesehenen flexiblen Ebenen berücksichtigt bzw. werden diese Längen entsprechend der endgültigen abgewinkelten Konfiguration eingestellt, so daß die gedruckte Schaltung später von selbst, das heißt ohne zusätzliche Biegebeanspruchung ihre gewünschte räumliche Konfiguration annimmt.

Die Festlegung der nötigen Längen $l_1$, $l_2$,...$l_n$ bzw. ihrer Radien $r_1$, $r_2$, ...$r_n$ in Abhängigkeit des jeweiligen Niveaus ($Z_1$, $Z_2$,...$Z_n$), das heißt in Abhängigkeit der Position des jeweiligen Flexkerns im gesamten Verbund der Mehrlagenschaltung erfolgt auf der Grundlage der folgenden Gleichung:

$$l_n = \frac{2\pi r_n \times \theta}{360}$$

Hierin bedeuten:

$l_n$ = die nötige Länge des Flexkerns im flex Bereich; und

$r_n$ = zugehöriger Radius, um die Winkelkonfiguration $\theta$ zu erreichen.

Zur Realisierung des erfindungsgemäßen Verfahrens können sehr vielfältige und verschiedene Stoffe eingesetzt werden. Das erfindungsgemäße Verfahren ist unabhängig von der zur Anwendung gelangenden Leiterplattentechnik und läßt sich besonders vorteilhaft mit der folgenden Kombination von Materialien durchführen:

Leiterplattentechnik:
Metallresist-, Additiv-, Semiadditiv-, Tentingverfahren oder weitere Verfahren.
Starre Materialien:
Thermoplastische Stoffe (z.B. PTFE) wie thermodure Polymere (mit und ohne Kupferkaschierungen oder Metallfolien), z.B. zweikomponentige Epoxi- oder Polyimid-Harze, wobei diese Materialien faserverstärkt sein können wie z.B. durch Glasgewebe, Quartz, Graphitfaser, Kevlar, Wirrglas.
Flexible Materialien:
Thermoplastische Stoffe (wie z.B. PTFE , mit und ohne Kupferkaschierungen), Thermodure -

(z.B. Polyimid), Polymere mit beliebigen Deckfolien (z.T. auch partiell) vorverpreßt.

Ferner können die folgenden Klebefolien verwendet werden: alle Arten von mehrkomponentigen reaktiven Harzen oder rein thermoplastische Verbundfolien unabhängig von der Art des Polymertyps bzw. unabhängig von der Art der Verstärkung (z.B. GFK) sowie unabhängig von jeder Kombination denkbarer Materialien.

Es sei ferner darauf hingewiesen, daß die vorliegende Erfindung nicht auf das gezeigte Ausführungsbeispiel beschränkt ist und sich die gleichen vorteilhaften Ergebnisse auch bei einer Gedruckten Schaltung realisieren lassen, bei welcher ein oder mehrere flexible Bereiche mit nur einem Niveau vorhanden sind. Auch ist das erfindungsgemäße Verfahren nicht auf die gezeigte Winkelstellung beschränkt sondern es sind ebensogut Konfigurationen realisierbar, bei welchen die einzelnen Abschnitte der Gedruckten Schaltung zusätzlich zu ihrer Abwinkelung noch in einer verdrehten Lage gehalten werden.

**Patentansprüche**

1. Verfahren zur Herstellung von Gedruckten Schaltungen in starrflexibler Mehrlagentechnik mit einem oder mit mehreren flexiblen Bereichen, die jeweils einen oder mehrere flexible Ebenen (14) aufweisen, wobei die fertiggestellten Gedruckten Schaltungen in einer abgewinkelten Konfiguration in eine Halterung eingesetzt und gehalten werden, dadurch **gekennzeichnet,** daß bei der Layouterstellung die für die spätere Konfiguration der abgewinkelten starrflexiblen Gedruckten Schaltung nötigen unterschiedlichen Längen ($l_1$, $l_2$, ..$l_n$) der vorgesehenen flexiblen Ebenen so eingestellt werden, daß die Gedruckte Schaltung von selbst, d.h. ohne Biegebeanspruchung ihre spätere räumliche abgewinkelte Konfiguration annimmt.

2. Verfahren nach Anspruch 1, dadurch **gekennzeichnet,** daß die nötigen Längen ($l_1$, $l_2$, ...$l_n$) der vorgesehenen flexiblen Ebenen in Abhängigkeit des Niveaus ($Z_1$, $Z_2$,...$Z_n$) der jeweiligen flexiblen Ebene im gesamten Verbund der Mehrlagenschaltung auf der Grundlage der folgenden Formel eingestellt werden:

$$l_n = \frac{2\pi r_n \times \theta}{360}$$

Worin bedeuten:

$l_n$ = nötige Länge der jeweiligen flexiblen Ebene im flexiblen Bereich, und

$r_n$ = zugehöriger Radius, um die Winkelkonfiguration $\theta$ zu erreichen.

3. Verfahren nach Anspruch 1 oder 2, dadurch **gekennzeichnet,** daß die flexiblen Bereiche unter Verwendung von thermoplastischen Materialien, Thermodur-Material wie Polyimid, Polymer-Material oder Polymer-Material mit Deckfolien hergestellt werden.

4. Verfahren nach Anspruch 3, dadurch **gekennzeichnet,** daß das Polymer-Material wenigstens teilweise mit Deckfolien vorverpresst ist.

5. Verfahren nach einem der Ansprüche 1 bis 4, dadurch **gekennzeichnet,** daß zur Herstellung der flexiblen Bereiche Klebefolien mit mehrkomponentigen reaktiven Harzen verwendet werden.

6. Verfahren nach einem der Ansprüche 1 bis 4, dadurch **gekennzeichnet,** daß zur Herstellung der flexiblen Bereiche rein thermoplastische Verbundfolien verwendet werden.

7. Verfahren nach einem der Ansprüche 1 bis 4, dadurch **gekennzeichnet,** daß zur Herstellung der flexiblen Bereiche zweikomponentige Epoxi- oder Polyimid-Harze verwendet werden.

8. Verfahren nach Anspruch 7, dadurch **gekennzeichnet,** daß die zweikomponentigen Epoxi- oder Polyimid-Harze faserverstärkt sind.

9. Verfahren nach Anspruch 8, dadurch **gekennzeichnet,** daß die Faserverstärkung aus Glasgewebe, Quarz, Graphitfasern, Kevlar oder Wirrglas besteht.

## Claims

1. A method of producing printed circuits employing rigid-flexible multi-layer technology with one or with a plurality of flexible zones each of which has one or a plurality of flexible levels (14), the finished printed circuits being used and supported in a holder in an angled-over configuration, characterised in that when preparing the lay-out, the various lengths ($1_1$, $1_2$, ...$1_n$) of the envisaged flexible levels required for the later configuration of the angled-over rigid-flexible printed circuit are so adjusted that the printed circuit automatically assumes what will be its subsequent spatial angled-over configuration without any flexural loading.

2. A method according to Claim 1, characterised in that the necessary lengths ($1_1$, $1_2$, ...$1_n$) of the envisaged flexible levels are adjusted as a function of the level ($Z_1$, $Z_2$, ...$Z_n$) of the relevant flexible level in the overall composite structure of the multi-layer circuit on a basis of the following formula:

$$1_n = \frac{2\pi \; r_n \times \theta}{360}$$

in which:

$1_n$ = the necessary length of the relevant flexible level in the flexible zone and

$r_n$ = associated radius in order to achieve the angular configuration $\theta$.

3. A method according to Claim 1 or 2, characterised in that the flexible zones are produced by using thermoplastics materials, thermosetting material such as polyimide, polymer material or polymer material with covering films.

4. A method according to Claim 3, characterised in that the polymer material is at least partially rough-pressed with covering films.

5. A method according to one of Claims 1 to 4, characterised in that to produce the flexible zones, adhesive films are used with multi-component reactive resins.

6. A method according to one of Claims 1 to 4, characterised in that solely thermoplastics composite films are used for producing the flexible zones.

7. A method according to one of Claims 1 to 4, characterised in that two-component epoxy or polyimide resins are used for producing the flexible zones.

8. A method according to Claim 7, characterised in that the two-component epoxy or polyimide resins are fibre-reinforced.

9. A method according to Claim 8, characterised in that the fibre-reinforcement consists of woven glass, quartz, graphite fibres, kevlar[(R)] or tangle glass.

## Revendications

**1.** Procédé de fabrication de circuits imprimés selon la technique multicouches rigide-souple avec une ou plusieurs zones souples comportant chacune un ou plusieurs plans souples (14), les circuits imprimés définitifs étant placés et maintenus en configuration pliée par un support dans lequel ils sont placés et maintenus, caractérisé en ce que les différentes longueurs ($l_1$, $l_2$, ... $l_n$) nécessaires des plans souples prévues lors du maquettage pour la configuration ultérieure des circuits imprimés rigides-flexibles pliées sont déterminées de façon telle que le circuit imprimé accepte de lui-même, c'est-à-dire sans contrainte de flexion, sa configuration dans l'espace ultérieure pliée.

**2.** Procédé selon la revendication 1, caractérisé en ce que les longueurs nécessaires ($l_1$, $l_2$, ... $l_n$) des plans souples prévues en fonction des niveaux ($Z_1$, $Z_2$, ... $Z_n$) de chaque plan souple sont déterminées pour toute la partie de liaison du circuit imprimé sur la base de la formule suivante :

$$l_n = \frac{2 \pi \, r_n \times \theta}{360}$$

dans laquelle :
$l_n$ représente la longueur nécessaire de chaque plan souple dans la zone souple et
$r_n$ représente le rayon correspondant à une configuration d'angle $\theta$.

**3.** Procédé selon la revendication 1 ou 2, caractérisé en ce que les zones souples sont réalisées par l'emploi de matières thermoplastiques, de matières thermodurcissables telles que des polyimides, de matières polymères, ou de matières polymères munies d'une feuille de couverture.

**4.** Procédé selon la revendication 3, caractérisé en ce que la matière polymère est au moins partiellement pré-comprimée avec des feuilles de couverture.

**5.** Procédé selon l'une des revendications 1 à 4, caractérisé en ce qu'on emploie des feuilles de collage à résines réactives à plusieurs composants pour la fabrication des zones souples.

**6.** Procédé selon l'une des revendications 1 à 4, caractérisé en ce qu'on emploie des feuilles de liaison purement thermoplastiques pour la fabrication des zones souples.

**7.** Procédé selon l'une des revendications 1 à 4, caractérisé en ce qu'on emploie des résines époxy ou polyimide à deux composants pour la fabrication des zones souples.

**8.** Procédé selon la revendication 7, caractérisé en ce que les résines époxy ou polyimide à deux composants sont renforcées par des fibres.

**9.** Procédé selon la revendication 8, caractérisé en ce que le renforcement par des fibres est constitué de tissu de verre, de quartz, de fibres de graphite, de kevlar, ou de verre stratifié.

EP 0 299 453 B1

STARRER
BEREICH 1

FLEXIBLER
BEREICH 3

STARRER
BEREICH 2

Fig. 1

Fig. 2

NIVEAU

13

12

RADIUS R1, LÄNGE 1
RADIUS R2, LÄNGE 2
RADIUS R3, LÄNGE 3

Z3   Z2   Z1

FLEXIBLE LAGEN 14

Fig. 3

EP 0 299 453 B1